Europäisches Patentamt

European Patent Office

Office européen des brevets

(11) Publication number: **0 051 378**
A2

(12) # EUROPEAN PATENT APPLICATION

(21) Application number: **81304853.5**

(22) Date of filing: **19.10.81**

(51) Int. Cl.³: **H 05 K 3/10**
**H 05 K 13/00**

(30) Priority: **03.11.80 US 203758**

(43) Date of publication of application:
**12.05.82 Bulletin 82/19**

(84) Designated Contracting States:
**DE FR GB IT NL**

(71) Applicant: **AMP INCORPORATED**
**Eisenhower Boulevard**
**Harrisburg, Pennsylvania(US)**

(72) Inventor: **Kimmel, David John**
**2588 Laural Wood Drive**
**Clearwater Florida 33515(US)**

(72) Inventor: **Marusak, Stephen Anthony**
**537 East Oak Ridge Avenue**
**New Port Richey Florida 33552(US)**

(74) Representative: **Terrell, Thomas Gwyn et al,**
**20 Queensmere**
**Slough, Berkshire SL1 1YZ(GB)**

(54) Circuit board having cast circuitry and method of manufacture.

(57) A circuit board (11) wherein the circuit traces (24, 24') are cast metal which lies in recesses (14) in a substrate (10). Continuity between traces (24, 24') on opposed surfaces (12, 12') of the board (11) is provided by metal in holes (16) through the substrate (10), which is cast through with lead-receiving holes (26) for reception of component leads. The boards (11) are manufactured by die casting metal into substrates (10) of heat resistant plastic which are premolded with recesses (14) in the desired circuit configuration. Metal is die cast into both surfaces (12, 12') of the board by means of casting apparatus (34) having a gate plate (54) which introduces metal against one surface (12) while metal flows to the other surface (12') through the holes (16) in the substrate (10). A pin plate (72) against the other surface (12') has retractable pins (94) which permit casting the lead-receiving holes (26).

Fig. 1

CIRCUIT BOARD HAVING CAST CIRCUITRY
AND METHOD OF MANUFACTURE

The present invention relates to circuitry such as printed circuit boards, and particularly to circuitry with the conductors cast into a substrate.

Prior art circuit boards referred to as printed circuit boards are generally made by applying conductive traces to a flat board. This is commonly done in several ways: (1) laminating copper foil to a substrate, stamping the foil with a die to shear it along desired circuit traces, and peeling away unwanted foil; (2) an additive process such as electrodeposit, either electrolytically or electrolessly, by selectively sensitizing the surface for ion deposition; (3) a substractive process such as laminating copper foil to a substrate and coating the surface with photoresist, selectively exposing the surface to light to decompose photoresist, etching away the exposed copper, then washing remaining photoresist off the circuit traces. Other methods used include preforming the circuit traces then forming the substrate thereto. Little work has been done using case metal in making circuitry, however, there is disclosed in US-A 3,160,930 and US-A 2,270,166 circuit members comprising dielectric support members and cast metal circuit traces. U.S. Patent No. 3,160,930 discloses an apparatus for casting metal onto the surface of a substrate. The apparatus employs a die plate and a platen with the circuit patterns formed therein and a substrate provided with holes so that

9433 EPC

metal may flow into circuit patterns in the platen against the opposite surface of the substrate. The apparatus is limited insofar as any circuitry change would require a die change, and the circuit traces are on the surface of the substrate and thus subject to mechanical damage. U.S. Patent No. 3,160,930 is instructive vis-a-vis the present invention, though, insofar as it details an apparatus used to introduce molten metal to a die plate. U.S. Patent No. 2,270,166 also discloses a circuit member having circuit traces cast on the surface thereof, but does not disclose details of the casting method or apparatus.

The present invention is directed primarily to a circuit board manufactured by casting metal into discrete recesses preformed in a heat resistant dielectric substrate. The recesses are formed to coincide with desired circuit traces, and traces may be continuous between opposite surfaces of the board via through holes. The apparatus used in the casting process involves a gate plate through which metal is introduced to one surface of the board and a pin plate which bears against the opposite surface. The board itself acts as a die. This simplifies the manufacture of the die plate and platen, especially where each surface of each board is generally confined to two dimensions, i.e., boards wherein the circuit traces are flush with the surface of the board. However, where added functionality of the board is desired by the addition of a third dimension feature, such as a switch mount, the plates which face the surfaces of the board during casting may be profiled to receive the feature molded integrally with the surface of the board.

As the boards must be premolded for a particular circuit, the product and process for making it are directed primarily to a mass produced board. Where large quantities are involved, the board of the present invention may be

-3-

manufactured much more economically than conventional printed circuit boards.

It is thus an object of the present invention to mass produce a circuit board relatively economically.

It is a related object to provide a rapid one step process for applying conductor to a premolded board.

It is a further object to provide positive mechanical retention of the circuitry to the board.

It is another object to provide a process for mass producing a circuit board which may be readily adapted for additional operative steps on the board.

It is another object to provide a process for producing a circuit board which produces no scrap material.

It is a further object to provide a process for producing a circuit board which does not require or produce toxic chemicals.

The accomplishment of these and other objects will be apparent from an examination of the accompanying drawings and the detailed description which follows.

FIGURE 1 is a perspective of the substrate prior to casting.

FIGURE 1A is a perspective of the finished circuit board.

FIGURE 2 is a cross-section of gating into opposite sides of the substrate prior to casting.

FIGURE 2A is a cross-section of gating into opposite sides of the board after casting.

FIGURE 3 is a cross-section of circuit board paths prior to casting.

FIGURE 3A is a cross-section of circuit board paths after casting.

FIGURE 4 is a front view of the casting apparatus.

FIGURE 5 is an end view of the apparatus taken along line 5-5 of Figure 4.

9433 EPC

-4-

FIGURE 6 is a top view of the apparatus prior to casting.

FIGURE 7 is a side cross-section of the apparatus and substrate prior to casting.

FIGURE 8 is a side cross-section of the apparatus and substrate during casting.

FIGURE 9 is a side cross-section as the slides are withdrawn from the gate plate.

FIGURE 10 is a side cross-section of the eject pins removing the slug metal from the piston slide.

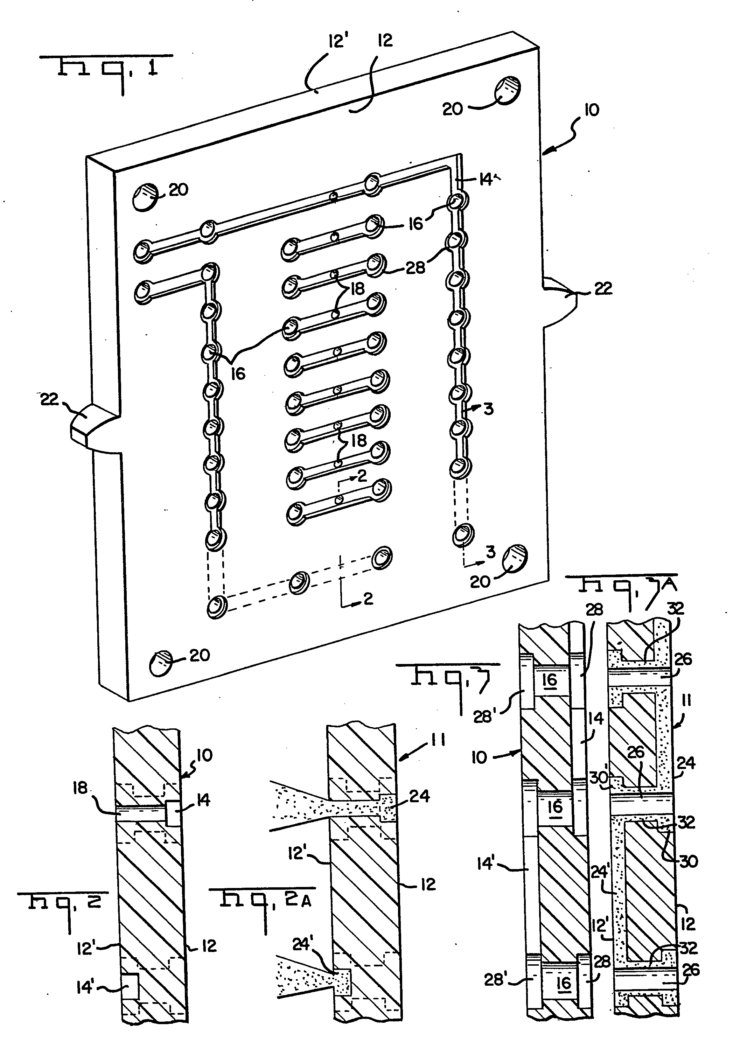

Figure 1 shows a molded dielectric support member or substrate 10 which is used as a base for the circuit board 11 of Figure 1A. The substrate has opposed surfaces 12, 12' which are profiled with recesses 14, 14' which correspond to the circuit traces 24, 24' of the finished circuit board 11. The substrate is perforated with through holes 16 and gate holes 18; the through holes 16 correspond to the lead-receiving holes 26 of the finished circuit board 11 and the gate holes 18 are filled solid in the finished board 11. The lead-receiving holes 26 are sized to accept leads of components assembled to the board, but the application of edge connectors to make contact with traces on either surface is also possible. The recesses 14, 14' are enlarged around the through holes 16 forming countersinks 28, 28' whose function in the finished board 11 will be explained. Other salient features of the substrate 10 include the aligning holes 20 in the four corners of the substrate and flat indexing posts 22 on opposed edges thereof.

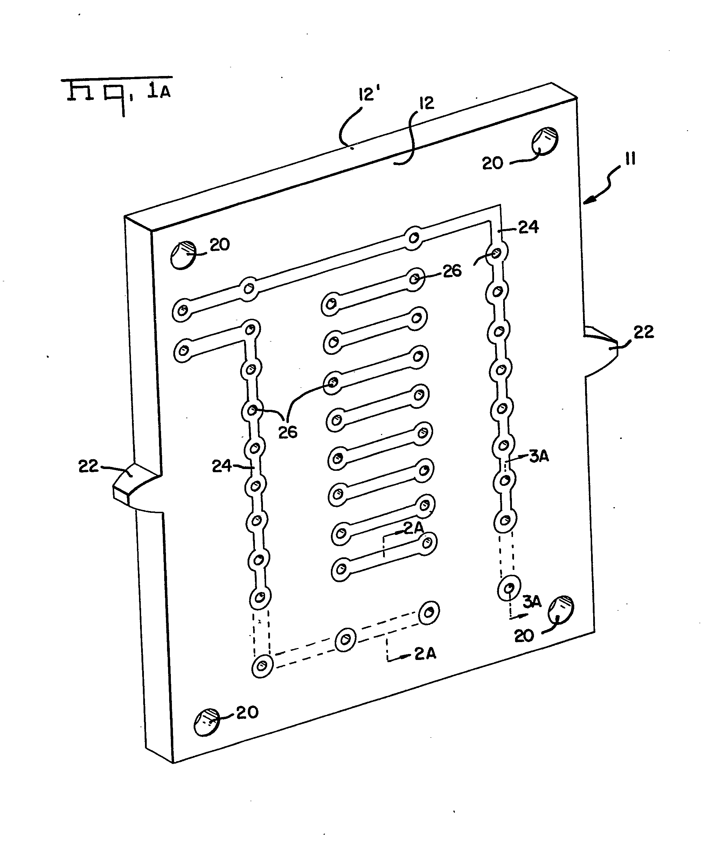

Figure 2 shows two points on the substrate where molten metal is cast into the substrate 10 to form the circuit traces 24, 24' of Figure 2A. The gate hole 18 of Figure 2 corresponds to a gate where molten metal enters the board and passes through to form a circuit trace 24 in a recess 14 in the opposite surface 12 from the gate, which will be described later in conjunction with the apparatus. Figure 2

9433 EPC

also shows a point where metal is cast into a recess 14' in surface 12' to form a circuit trace 24'; no gate hole is necessary since the metal is cast directly into a recess 14' on the same side of the substrate as the gate on the casting apparatus.

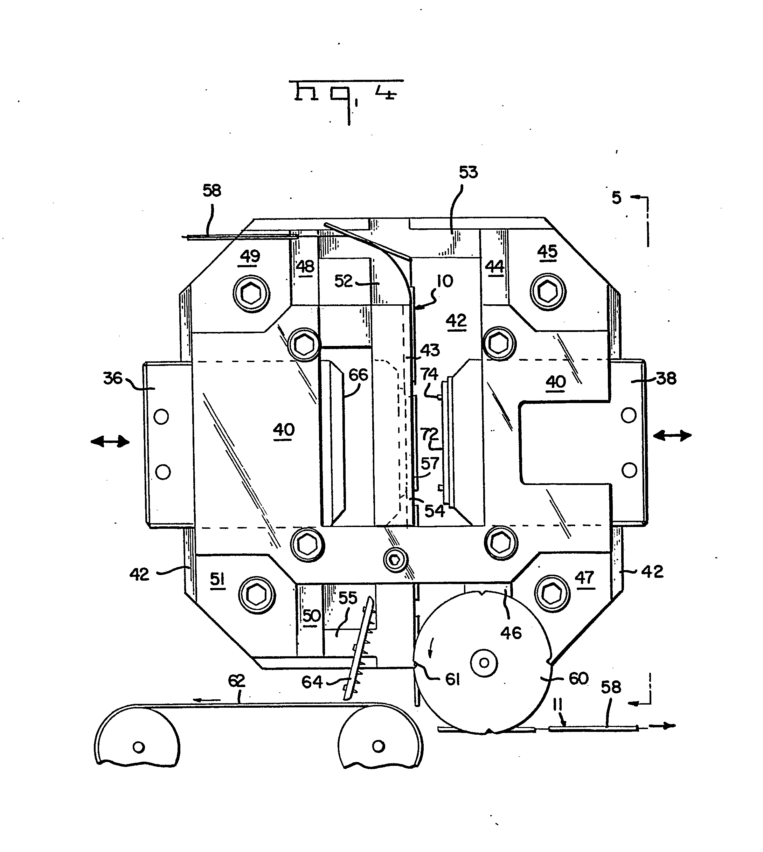

Figure 3 shows three through holes 16 in the substrate 10 which correspond to lead-receiving holes 26 in the finished board 11 of Figure 3A. Each through hole 16 is faced on each surface 12, 12' by a countersink 28, 28' as previously described. Conductive metal is cast around pins, which will be described later, leaving the lead-receiving holes 26 in the board 11. The pins are smaller than the through holes 16 in the substrate so that the metal flows around the pins forming a spool of metal 32 around the lead-receiving hole 26 and allows electrical continuity between the surfaces 12, 12' in the manner of a plated through hole or via hole of a conventional board. Note that the cast metal in Figure 3A is a single continuum of metal whereby electrical leads inserted in the pin holes are common, such as a ground. Flanges of metal 30, 30' formed in the countersinks 28, 28' as part of spools 32 help anchor the circuitry to the board. This feature is particularly useful during component insertion, which as an interference fit could otherwise loosen spool 32 from the through hole 16 in the substrate 10.

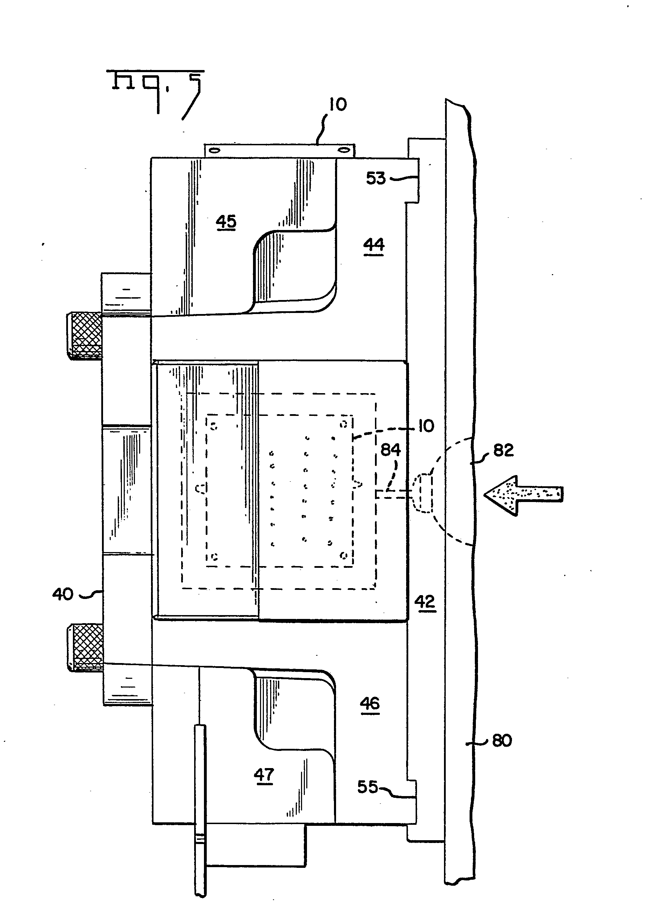

Manufacture of the above described board is accomplished by the die casting apparatus 34 shown orthogonally in Figures 4, 5, and 6; Figure 4 is a front view. Salient features include the gating slide 36 and the pin plate slide 38 which are guided from opposed directions into a work zone between the cover 40, base plate 42, and guide brackets 44, 46, 48, 50 which are held in place by bracket supports 45, 47, 49, 51 respectively. A stationary gate plate 54 has a casting surface 57 facing the work zone and is fit into center frame piece 43 which lies between cover 40 and base plate 42. An indexing device 60 draws a strip of substrates 58 through the work zone by action acting on the posts 22 on the boards, which are strung together by a continuous strip of tape (metal or high temperature plastic) on either side of the boards. A slug of metal 64 is shown dropping out of the work zone onto a conveyor 62 which will carry it back to a melting furnace (not shown) for re-use in casting. Extractor plate 66, mounted to gating slide 36, cooperates with gate plate 54 during the casting process, as will be described. Pin plate 72 cooperates with the substrate 20 and is aligned thereto by fitting aligning posts 74 into aligning holes 20 (Figure 1). Channels 52, 53, 55 visible in the base plate 42 serve to position the brackets and center frame 43 as will be apparent in Figures 4, 5, and 6.

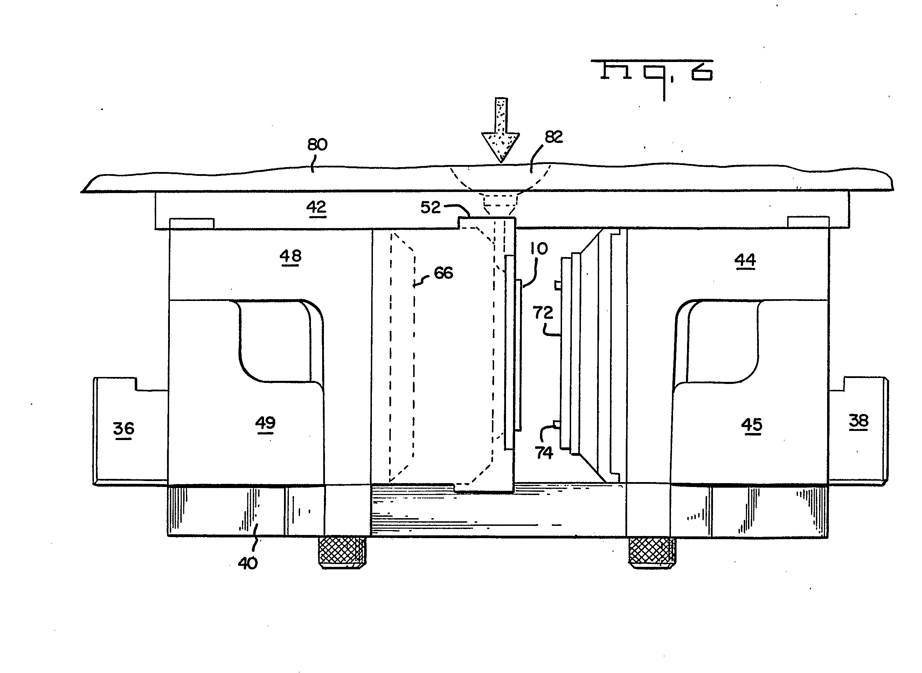

Figure 5 is an end view which shows the substrate in phantom in the work area. The geometry of the guide brackets 44, 46 and bracket supports 45, 47 is also apparent; these are similar to brackets 48, 50 and supports 49, 51 which would be visible from the opposite end. Channel 53 positions brackets 44, 48 while channel 55 positions brackets 46, 50. Base plate 42 is mounted to a vertical table 80 which contains the metal injecting equipment. The injection gate 82 in the table supplies molten metal through port 84 in the base plate to the work zone. Injecting equipment is old in the art as exemplified by U.S. Patent No. 3,160,930, which is hereby incorporated by reference.

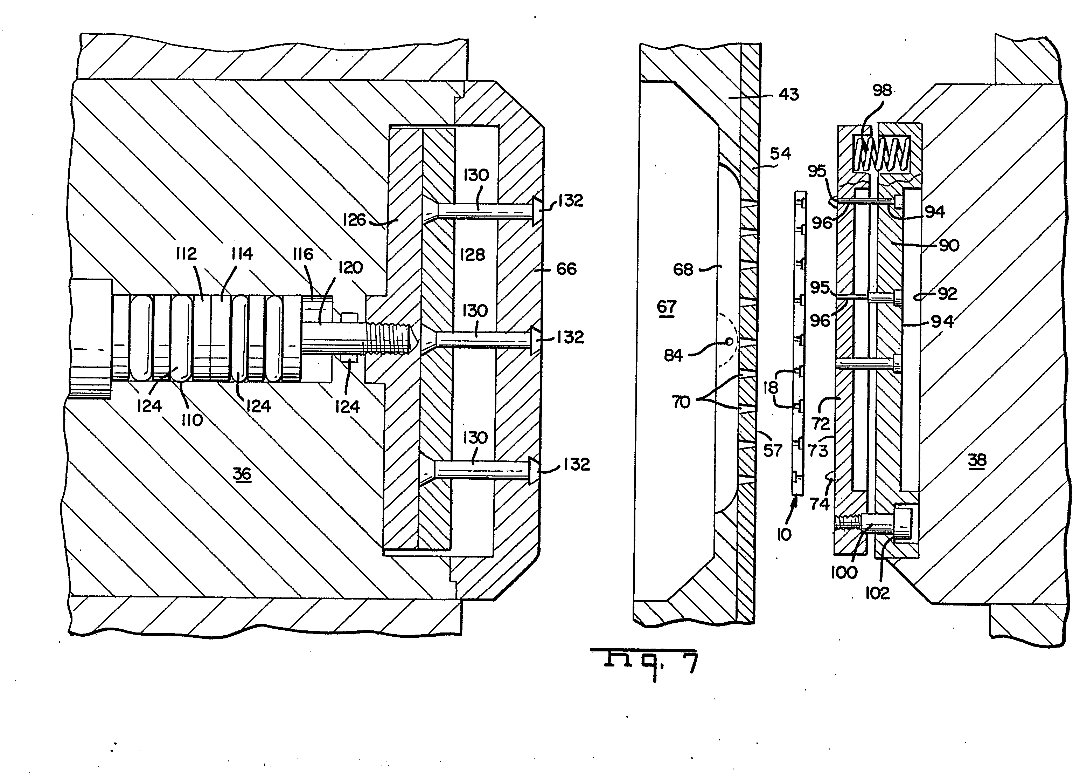

Figure 6 is a top view which provides good vantage of the work zone.

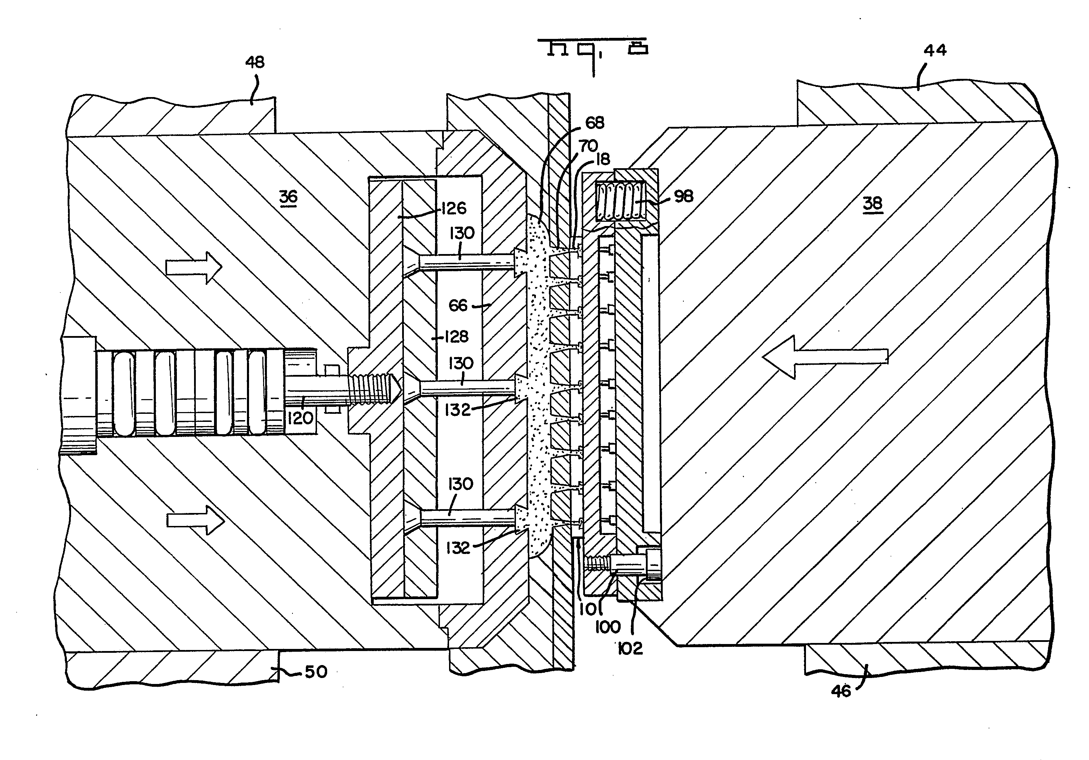

Figure 7 shows details of the work zone prior to the casting operation. A platen 90 is mounted to the leading face 92 of pin plate slide 38. Core pins 94 are fixedly mounted in the platen 90 and have leading ends 95 which enter pin holes 96 in the pin plate 72. Springs 98 located

9433 EPC

in the four corners of the pin plate serve to urge the pin plate 72 resiliently away from the platen 90 as four shoulder screws 100 bear against shoulders 102 in the platen to retain the plate thereto. The screws 100 are located at midpoints in the sides of the pin plate adjacent to the edges, each screw lying between two springs 98.

Referring still to Figure 7, an oil cylinder 110 bored in the gating slide 36 houses a sealing piston 112 and a drive piston 114 which acts on pressure plate 126 through piston rod 120. A return chamber 116 in the cylinder contains oil under pressure to hold the drive piston in this position. Seals 124 are set in annular recesses on the pistons 112, 114 and in the slide 36 surrounding the piston rod 120 to prevent oil leakage. Mounting plate 128 is fixed to the pressure plate 126 and carries ejector pins 130, the leading ends of which enter bores through the extractor plate 66. The extractor plate is fixedly mounted to the gating slide 36 and is profiled with frustoidal recesses 132. The center frame piece 43 is profiled with a concavity 67 to closely receive the extractor plate 66 and is further profiled with a reservoir 68 which is closed by moving the gating slide 36 toward the stationary gating plate as will be described. The center frame piece 43 is profiled with gates 70 which connect the reservoir 68 to the casting surface 67 of the gating plate, where molten metal is introduced to the substrate.

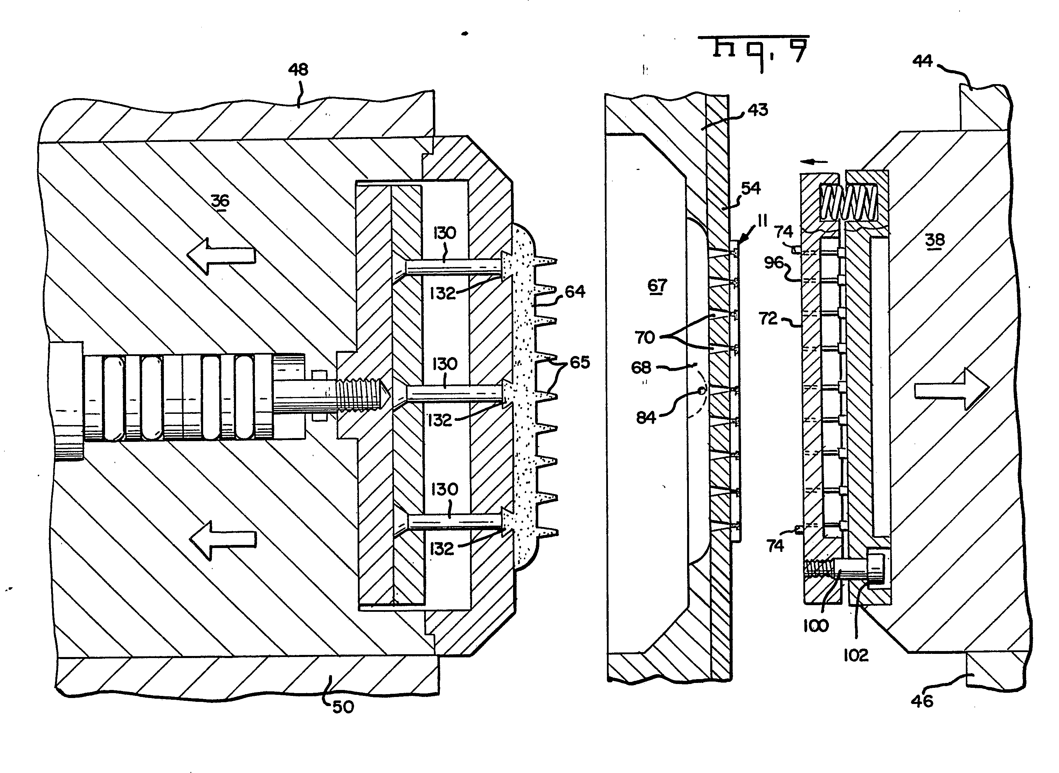

The operation of the casting apparatus will now be described; this is shown cross-sectionally in Figures 7, 8, 9, and 10. Figure 7, described above, shows the system prior to movement of the slides 36, 38 inward toward the gating plate 54. The substrate 10 would be against the casting surface 57 of gating plate 54 with the gates 70 meeting the gate holes in actual operation. The cross-section of the substrate in these views is taken on a line through the gate holes 18; the through holes are not visible. The slides are moved in to the position of Figure 8, so that casting surface 73 of pin plate 72 bears against the substrate. This movement brings the extractor plate 66 into the concavity 67 in the center frame piece 43 to close the reservoir 68 and compresses the springs 98 between the pin plate 72 and the platen 90, forcing the leading ends 95 of the core pins 94 through the pin holes in the pin plate and through the center of the through holes 16 in the substrate 10 (visible in Figure 1). Molten metal is then introduced into the reservoir through port 84 (visible in Figure 7) from the injecting equipment.

The metal, a tin-lead alloy or a zinc alloy is introduced to the reservoir quite rapidly. The metal flows through the gates 70 and into the recesses 14, 14' in the board to form the circuit traces 24, 24' (Figures 2 and 2A) by flowing through the gate holes 18 and around the leading ends 95 of pins 94 in through holes 16 to fill recesses on the opposed surface 12 of the board. Metal also fills frustoidal recesses 132 in the extractor plate 66. The metal crystallizes rapidly after injection is complete due to heat sink properties of the casting apparatus and substrate.

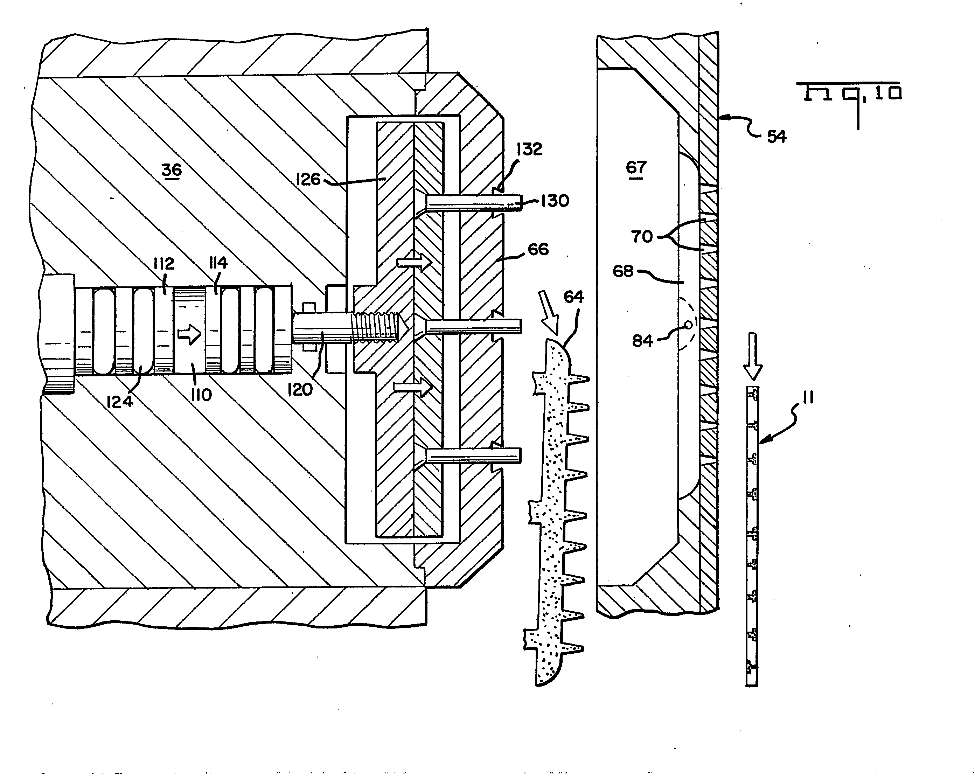

Figure 9 depicts the slides as they are withdrawn from the work zone. The slug of metal 64 which solidified in reservoir 68 is withdrawn therefrom readily as metal fingers 65 which filled the gates 70 are conical in shape for easy retraction. The slug is held to the extractor plate due to the shape of the portions of metal crystallized in the frustoidal recesses 132 in the extractor plate. The springs 98 between the platen 90 and pin plate 72 expand to draw the pins 94 from the lead-receiving holes 26 in the finished board 11 and into the pin holes 96 in the pin plate 72 as the pin plate slide 38 is withdrawn. Aligning posts 74 are pulled from aligning holes 20 (Figure 1A) in board 10 during the same movement.

9433 EPC

Figure 10 depicts the ejection of the slug 64 from the extractor plate 66 by the action of ejector pins 130 moving into the frustoidal recesses 132. This deforms the portions of crystallized slug metal therein and the slug 64 falls away by gravity. Movement of the ejector pins is effected by introducing fluid under pressure into the cylinder 110 between the sealing piston 112 and the drive piston 114 while drawing fluid from the return chamber 116. Fluid is then introduced into the return chamber again to withdraw the ejector pins. The indexing device 60 is rotated to move the board 11 downward while the next substrate 10 moves into place, and the operation is ready for repetition.

An important advantage of carrying the boards by means of Mylar tape affixed to flat indexing posts is that it assures the boards remain oriented relative to the tape. The boards are fed to the apparatus from a reel and pass between the pin plate and gate plate without having to be repositioned from the feed path. Here the use of the sprung pin plate 72 with retractable pins 94 is another major advantage, as the board 10 may continue on a linear feed path without having to be withdrawn from the pin plate 72. Without springs 98 between the pin plate 72 and the platen 90, the leading ends 95 of pins 94 could stick in the crystallized conductor and present a problem in an automated process. The aligning posts 74 are profiled to fit loosely in aligning holes 20 and thus withdraw readily from board 10 as the pin plate slide 38 retreats after casting. While another board moves into place, the cast boards may be carried on the Mylar tape to another work station for an additional operation.

It should be recognized that stand-offs may be cast above the surface of the board by providing an appropriate profile in the gating plate or the pin plate. For example, a swedge or crimp connection for terminating a lead off a circuit component can be molded by profiling a recess into

9433 EPC

the gating plate which complements the desired shape of the stand-off and providing a longer pin which would extend through the component hole into the recess in the gating plate. Where automatic loading of components is desired, the lead-receiving holes 26 in finished board 11 (Figure 3A) may be cast with tapered lead-ins to facilitate insertion.

The materials for the substrate and the casting metal selected for the practice of the invention must satisfy certain requirements as discussed below in regard to temperature characteristics, physical strength and stability. In general, the substrate must be such that it is not degraded or otherwise damaged when it is placed in the die and contacted by the hot metal. Otherwise, the material for the substrate should have physical properties which are comparable to the properties of the materials presently being used for circuit boards such as thermoplastic filled with glass. The metal selected for the practice of the invention should have satisfactory electrical properties, but since the conductors are relatively large cross sections, these electrical properties need not be comparable to the properties of copper. It is, however, important that the metal be capable of withstanding the temperatures to which it is exposed when a circuit board, in accordance with the invention, is passed through a wave soldering bath.

The materials selected for the substrate should, as a practical matter, have a UL service rating of 500 degrees Fahrenheit or more for the reason that during the die casting, the die will reach a temperature of 500 degrees. Obviously, then, the substrate must not be damaged when it is exposed to temperatures in this range. It should be mentioned that it is not necessary that the substrate be capable of withstanding the temperature of 500 degrees Fahrenheit for an extended time period since the substrate is in the mold for only about 10 seconds.

9433 EPC

Not all materials which have the required UL service rating will be found satisfactory for the process. Since the substrate is weakened by the relatively deep (0.20") channels on its surface, it is desirable to choose a material which has good impact strength so that it will be able to withstand ordinary handling, notwithstanding the weakening effects of the channels.

It has been found that thermosetting polyesters filled with relatively long glass fibers are satisfactory for the practice of the invention in that the relatively long fibers, about ½" in length, impart the required impact strength to the circuit board and the material is capable of withstanding the elevated temperature environment of the die for a short period. Good results have been obtained with Glastic 1412 which is manufactured by Glastic Corporation of Cleveland, Ohio. Certain thermoplastic materials such as polyphenylene sulfide filled with mineral fibers can also be used, such as Ryton R10 which is manufactured by Phillips Chemical Company. Still other materials might be used for specialized circumstances and unusual environments. Polysulfone might be used where the circuit board will be placed in a high frequency environment or where extremely high dimensional stability is an important consideration. The polysulfone materials are high priced and are not generally suitable for ordinary applications for this reason.

The casting metal selected might be any one of several known alloys, but must be selected with certain requirements in mind. The casting metal should exhibit good flow characteristics and it should remain solid at the temperature of any solder bath to which the circuit board will be exposed. As a practical matter, good wave soldering practice with the commonly used 63Sn 37Pb solder requires that the bath be maintained within the temperature range of about 500-510 degrees Fahrenheit. The casting metal will usually be an

9433 EPC

-12-

alloy and should have a solidus temperature which is above about 505 degrees Fahrenheit. The solidus temperature should be higher than the temperature of the solder bath for the reason that if the casting metal is rendered pasty as a result of partial melting during soldering, the surfaces of the conductors may be disturbed and the conductors after soldering will not be uniformly distributed in the channels. Also, the conductors might fall out of the channels if they become pasty.

Good results have been obtained with a 95Pb 5Sn alloy which has a solidus temperature of 518 degrees Fahrenheit and a liquidus of 597 degrees Fahrenheit. Pure lead may be used under some circumstances, particularly if the channels are relatively deep and the board design does not present flow problems for the metal.

CLAIMS:

1. A circuit member (11) of the type comprising a dielectric support member (10) and cast metal circuit traces (24, 24'), characterized in that said support member (10) has on at least one surface (12, 12') thereof a pattern of discrete recesses (14, 14') which coincide with circuit paths (24, 24'), said circuit member (11) having cast conductive material in said recesses (14, 14').

2. A circuit member (11) as in claim 1, characterized in that said dielectric support member (10) has two opposed, planar, parallel surfaces and holes (16, 18) which communicate between said surfaces (12, 12'), each said hole (16, 18) communicating with a recess (14, 14') in at least one of said surfaces (12, 12'), and said cast conductive material lies in said holes (16, 18) and forms continua of metal between the surfaces (12, 12').

3. A circuit member (11) as in claim 2, characterized in that some of said continua of metal between said surfaces (12, 12') define lead-receiving holes (26) between said surfaces, each said lead-receiving hole (26) being concentric with and of smaller diameter than the hole (16) within which the respective continuum of metal lies.

4. A circuit member as in claim 1, characterized in that said conductive metal lying in said recesses is flush with said surface.

5. A circuit board (11) of the type comprising a molded dielectric support member (10) and cast metal circuit traces (24, 24'), characterized in that said support member (10) has two opposed, generally flat, parallel surfaces (12, 12'), at least one of said surfaces (12, 12') having a pattern of discrete recesses (14, 14') therein, said recesses (14, 14') coinciding with circuit paths (24, 24'), said support member having a plurality of holes (16, 18) therethrough between said surfaces (12, 12'), each said hole

9433 EPC

(16, 18) communicating with a recess (14, 14') in at least one of said surfaces (12, 12'), said circuit board (11) having cast conductive metal in said recesses (14, 14') and holes (16, 18), said metal generally filling said recesses (14, 14') and being generally flush with said surfaces (12, 12'), said metal in said holes forming discrete continua of metal between the surfaces (12, 12').

6. A circuit board (11) as in claim 5 characterized in that some of said continua of metal between said surfaces (12, 12') define lead-receiving holes (26) between said surfaces (12, 12'), each said lead-receiving hole (26) being concentric with and of smaller diameter than the hole (16) within which the respective continuum (32) of metal lies.

7. A circuit board (11) as in claim 6 characterized in that each hole (16) having a continuum of metal therein having a lead-receiving hole (26) therein is countersunk at each surface (12, 12'), said continuum of metal in each hole (16) being in the shape of a spool (32) having flanges (30) in the countersink (28) at each surface, whereby said flanges (30) serve to anchor said cast conductive metal in said dielectric support member.

8. A circuit board (11) of the type comprising a molded dielectric support member (10) having two opposed, generally flat, parallel surfaces (12, 12') thereon and cast metal circuit traces (24, 24') characterized in that said support member is manufactured by the steps of molding at least one of said surfaces (12, 12') with a pattern of discrete recesses (14, 14') therein, each recess (14, 14') coinciding with a circuit path (24, 24'), said circuit board (11) having a plurality of holes (16, 18) therethrough between said surfaces (12, 12'), each said hole (16, 18) communicating with a recess (14, 14') in at least one of said surfaces, inserting a core pin (94) into each of some of said holes (16, 18), each said core pin (94) being smaller than its respective hole (16), die casting

9433 EPC

conductive metal into said recesses (14, 14'), said holes (16, 18) providing paths whereby said metal may flow between said surfaces, and removing said core pins (94) from respective holes (16) after metal is cast thereby leaving lead-receiving holes (26) through the conductive metal in the board (11).

9.    A method of making a circuit board (11) of the type comprising a molded dielectric support member (10) having two opposed, generally flat, parallel surfaces (12, 12') thereon and cast metal circuit traces (24, 24'), characterized by the steps of molding a pattern of discrete recesses (14, 14') in at least one of said surfaces (12, 12'), each recess (14, 14') coinciding with a circuit path (24, 24'), said circuit board (11) having a plurality of holes (16, 18) therethrough between said surfaces (12, 12'), each said hole (16, 18) communicating with a recess (14, 14') in at least one of said surfaces (12, 12'), casting conductive metal into said recesses (14, 14'), said holes (16, 18) providing paths whereby said metal may flow between said surfaces (12, 12').

10.    A method as in claim 9 characterized in that said metal is die cast.

11.    Apparatus (34) for die casting metal to form circuit traces (24, 24') carried by a generally flat substrate (10) having opposed parallel surfaces (12, 12'), said apparatus (34) being of the type comprising a gate plate (54) having a generally flat casting surface (57) which is brought into one surface (12) of said substrate (10) and gates (70) therethrough which communicate between said casting surface (57) and a molten metal reservoir (68), said apparatus (34) further comprising means for introducing molten metal into said reservoir, said apparatus (34) further comprising a pin plate (72) having a generally flat casting surface (73) which is brought into contact with the other surface of the substrate (10), said pin plate (72)

9433 EPC

having pin holes (96) therethrough and core pins (94) closely thereon, said pin holes (96) being arranged to communicate with an array of through holes (16) in said substrate (10) which intersect both surfaces (12, 12') thereof, <u>characterized in that</u> said pin plate (72) is resiliently mounted to a platen (90) having said core pins (94) fixedly mounted thereto, whereby, said substrate (10) is sandwiched between said casting surface (57) of said gate plate (54) and said casting surface (73) of said pin plate (72), said core pins (94) emerging from said pin holes (96) and entering said through holes (16) as said casting surface (73) of said pin plate (72) bears against said other surface (12') of said substrate (10), said molten metal is introduced into said reservoir (68) and flows via said gates into said through holes (16), said metal crystallizes and said platen (90) is withdrawn, drawing said core pins (94) into said pin holes (96) and leaving metal defining lead-receiving holes (26) in said through holes (16) in said substrate.

0051378

0051378

2.

Fig. 1A

3.

Fig. 4

0051378

4

Fig. 5

10

53

45

44

10

84

82

40

42

80

46

47

55

5.

Fig.6

6.

Fig. 7

Fig. 7.

48

44

36

38

68
70
18
98

126
130

66

128

130

132

120

130

132

101
100
102

50

46

0051378

Fig. 9

Fig. 10

36

126

132

130

112    114

66

124    110    120

64

67

70

68

84

54

11

9

0051378